# EUROPEAN PATENT APPLICATION

(11) **EP 4 611 074 A1**
(43) Date of publication of application: **03.09.2025**
(21) Application number: 23881244.0
(22) Date of filing: 14.06.2023
(51) Int. Cl.: H01M 4/62, H01M 4/38, H01M 10/0525

(54) **THREE-DIMENSIONAL NETTED STRUCTURE COMPOSITE MATERIAL FOR LITHIUM BATTERY, AND PREPARATION METHOD THEREFOR AND USE THEREOF**

(30) Priority: 24.10.2022 CN 202211298670
(71) Applicant: Tianmulake Excellent Anode Materials Co, Ltd., Liyang, Jiangsu 213330 (CN)
(72) Inventor: LIU, Bonan, Jiangsu 213300 (CN); LUO, Fei, Jiangsu 213300 (CN)
(74) Representative: Glück Kritzenberger Patentanwälte PartGmbB
(86) International application number: PCT/CN2023/100100
(87) International publication number: WO 2024/087653

(57) **Abstract**

Disclosed in the present invention are a three-dimensional netted structure composite material for lithium batteries, and a preparation method and the use thereof.The three-dimensional netted structure composite material comprises:a porous carbon microsphere containing netted structure through holes, silicon nanowires distributed in the through holes of the porous carbon microsphere, and a carbon shell. The silicon nanowires are formed by catalyzing, by means of Au or Ag,a silicon-containing gas and depositing same in the through holes; or the silicon nanowires are formed by depositing a silane gas in the through holes to form silicon oxide nanoparticles, then electrolyzing the silicon oxide nanoparticles in the through holes undder a molten salt system. The silicon nanowires form three- dimensional netted structures in through holes of the porous carbon microsphere. Applying the three- dimensional netted structure composite material as a negative electrode active material in a lithium battery can endow the lithium battery with a relatively low volume expansion rate, a relatively high mass specific capacity, and good conductive performance and cycling stability.

## Description

### CROSS-REFERENCE TO RELATED APPLICATION

This application claims priority for Chinese patent application No. 202211298670.7, entitled "THREE-DIMENSIONAL NETTED STRUCTURE COMPOSITE MATERIAL FOR LITHIUM BATTERIES, AND PREPARATION METHOD AND APPLICATION THEREOF", filed with China National Intellectual Property Administration on October 24, 2022.

### BACKGROUND OF THE INVENTION

### 1. Technical Field

The invention relates to the technical field of lithium battery materials, in particular to a three-dimensional netted structure composite material for lithium batteries, and a preparation method and application thereof.

### 2. Description of Related Art

Silicon-based anode materials have a very high specific capacity, over ten times that of commercial graphite, making them popular as anode materials for lithium-ion batteries. However, silicon-based anodes experience significant volume changes during electrochemical processes, leading to the formation of an unstable SEI membrane on their surface.

To mitigate the volume expansion of silicon particles and prevent their pulverization, people utilize carbon coating or manage the porosity of porous materials. Additionally, the carbon coating ensures the stability of the SEI membrane on the surface of the anode material, thereby preventing continuous consumption of Li⁺ by the SEI membrane. The carbon coating somewhat limits the volume changes of silicon particles during lithiation; however, micro-cracks still occur during the cycling process, leading to structural damage of the material.

Therefore, it is necessary to develop a composite material that effectively controls volume expansion, prevents the formation of micro-cracks on the material surface during cycling, and improves the charging and discharging performance as well as the cycling stability of batteries.

### BRIEF SUMMARY OF THE INVENTION

Embodiments of the present invention provide a three-dimensional netted structure composite material for lithium batteries, and a preparation method and application thereof. The three-dimensional netted structure composite material is obtained by in-situ growing silicon nanowires in through holes of porous carbon microspheres using chemical deposition or molten salt electrolysis, followed by carbon coating. When used as the anode active material in lithium batteries, the three-dimensional netted structure composite material can achieve a lower volume expansion rate, higher mass specific capacity, and good electrical conductive performance and cycling stability.

In a first aspect, an embodiment of the present invention provides a three-dimensional netted structure composite material for lithium batteries, comprising porous carbon microspheres with netted structure through holes, silicon nanowires distributed within the through holes of the porous carbon microspheres, and a carbon shell;
wherein the silicon nanowires are formed by catalyzing silicon-containing gas by Au or Ag and depositing same in the through holes by Au or Ag; which including Au or Ag is first evaporated and deposited onto walls of the through holes of the porous carbon microspheres to create an Au or Ag metallic membrane, and then, the silicon-containing gas is introduced, allowing Au or Ag to catalyze the silicon-containing gas, so that precipitating silicon atoms, depositing the silicon atoms in the through holes to form the silicon nanowires;
alternatively, the silicon nanowires are formed by depositing silane gas in the through holes to form silicon dioxide nanoparticles , and electrolyzeing the silicon dioxide nanoparticles in the through holes under a molten salt system ;
the silicon nanowires form a three-dimensional netted structure structure in the through holes of the porous carbon microspheres; and
an average pore diameter of the through holes of the porous carbon microspheres ranges from 15 nm to 50 nm.

Preferably, the porous carbon microspheres account for 30% to 70% of the total mass of the three-dimensional netted structure composite material;
the silicon nanowires account for 15% to 60% of the total mass of the three-dimensional netted structure composite material; and
a particle size Dv50 of the three-dimensional netted structure composite material ranges from 1 µm to 100 µm.

Preferably, the carbon shell envelops an outermost layer of the three-dimensional netted structure composite material, and the carbon shell accounts for 1% to 20% of the total mass of the three-dimensional netted structure composite material.

In a second aspect, an embodiment of the invention provides a preparation method of the three-dimensional netted structure composite material as described in the first aspect, which comprises:
under a protective atmosphere, placing porous carbon microspheres with netted structure through holes in a deposition device, and evaporating and depositing Au or Ag onto walls of the through holes of the porous carbon microspheres to form an Au or Ag metallic membrane that acts as a catalyst;
introducing a gas of silicon source material into the deposition device for vapor deposition, allowing the gas of silicon source material to deposit on a surface of the metallic membrane, and then heating to increase the temperature, allowing the formation of silicon nanowires under the catalytic action of metal Au or Ag, to obtain a precursor material containing three-dimensional netted structure silicon nanowires; and
performing carbon coating on the precursor material containing the three-dimensional netted structure silicon nanowires to form a carbon shell, yielding the three-dimensional netted structure composite material.

Preferably, the protective gas is nitrogen or argon, and a flow rate of the protective gas is 1 L/min to 50 L/min;
the silicon source material comprises silicon-containing gas and/or silicon-containing liquid;
the silicon-containing gas comprises silane and/or dichlorosilane;
the silicon-containing liquid comprises one or more of propyl silane, trichlorosilane, tetrachlorosilane, trimethoxysilane, tetramethoxysilane, triethoxysilane and tetraethoxysilane;
when the silicon source material is in the form of silicon-containing gas, the silicon-containing gas is introduced directly or via a carrier gas into the deposition device, a flow rate of the silicon-containing gas is 0.5 L/min to 50 L/min, and the carrier gas is nitrogen or argon, with a flow rate between 0.5 L/min and 50 L/min; and
when the silicon source material is in the form of silicon-containing liquid, the silicon-containing liquid is introduced into the deposition device in a bubbling form using a carrier gas, and the carrier gas is nitrogen or argon, with a flow rate between 0.5 L/min and 50 L/min.

Preferably, the deposition device comprises any one of a rotary furnace, a tube furnace, a bell jar furnace or a fluidized bed;
the gas of silicon source material is introduced into the deposition device for vapor deposition at the temperature of 600°C-1200°C for 1-20 hours;
the method for carbon coating comprises any one of gas phase coating, liquid phase coating and solid phase coating; the carbon shell formed by the carbon coating accounts for 1% to 20% of the total mass of the three-dimensional netted structure composite material; and
the method for introducing the gas of silicon source material into the deposition device for vapor deposition comprises a thermal plasma technique.

In a third aspect, an embodiment of the invention provides a preparation method of the three-dimensional netted structure composite material as described in the first aspect, which comprises:
under a protective atmosphere, placing porous carbon microspheres with netted structure through holes in a deposition device, and introducing a gas of silicon source material into the deposition device for vapor deposition, depositing the gas of silicon source material in the through holes of the porous carbon microspheres, to obtain a precursor material;
placing the precursor material in an electrolytic cell for electrolysis, where the precursor material acts as a cathode, graphite as an anode and a molten salt system as an electrolyte, controlling a voltage and temperature of the electrolytic cell, and applying electricity in an argon atmosphere,decomposing silicon dioxide deposited in the through holes of the porous carbon microspheres , forming silicon nanowires and yielding an electrolytic material containing three-dimensional netted structure silicon nanowires; and
performing cooling, washing, vacuum drying, carbon coating, and sieving on the electrolytic material to produce the three-dimensional netted structure composite material.

Preferably, the protective gas is nitrogen or argon, and a flow rate of the protective gas is 1 L/min to 50 L/min;
the silicon source material comprises silicon-containing gas and/or silicon-containing liquid;
the silicon-containing gas comprises silane and/or dichlorosilane;
the silicon-containing liquid comprises one or more of propyl silane, trichlorosilane, tetrachlorosilane, trimethoxysilane, tetramethoxysilane, triethoxysilane and tetraethoxysilane;
when the silicon source material is in the form of silicon-containing gas, the silicon-containing gas is introduced directly or via a carrier gas into the deposition device, a flow rate of the silicon-containing gas is 0.5 L/min to 50 L/min, and the carrier gas is nitrogen or argon, with a flow rate between 0.5 L/min and 50 L/min; and
when the silicon source material is in the form of silicon-containing liquid, the silicon-containing liquid is introduced into the deposition device in a bubbling form using a carrier gas, and the carrier gas is nitrogen or argon, with a flow rate between 0.5 L/min and 50 L/min.

Preferably, the deposition device comprises any one of a rotary furnace, a tube furnace, a bell jar furnace or a fluidized bed;
the gas of silicon source material is introduced into the deposition device for vapor deposition at the temperature of 600°C-1200°C for 1-20 hours;
the method for carbon coating comprises any one of gas phase coating, liquid phase coating and solid phase coating; the carbon shell formed by the carbon coating accounts for 1% to 20% of the total mass of the three-dimensional netted structure composite material; and
the method for introducing the gas of silicon source material into the deposition device for vapor deposition comprises a thermal plasma technique.

In a fourth aspect, an embodiment of the invention provides a lithium battery, which comprises the three-dimensional netted structure composite material as described in the first aspect.

The embodiments of the invention provide a three-dimensional netted structure composite material, and a preparation method and application thereof. The silicon nanowires are grown in situ within the through holes of the porous carbon microspheres through chemical deposition or molten salt electrolysis, and then coated with carbon to obtain the three-dimensional netted structure composite material. On the one hand, the through holes of the porous carbon microspheres serve as the skeleton structure, possessing high mechanical strength. When subjected to the expansion force of lithium intercalation, the high-strength skeleton structure can effectively inhibit the volume expansion of the silicon nanowires, maintain the structural stability of the anode material, and improve the cycling performance of the material. On the other hand, the silicon nanowires form an interwoven three-dimensional netted structure structure within the through holes, which not only increases the capacity of the material but also forms an interconnected conductive network, enabling the battery assembled with the anode material to have a higher specific charge capacity and superior conductivity. In addition, compared to silicon particles, the three-dimensional netted structure silicon nanowires exhibit better electrical conductivity, possess superior conductive properties at an electrode/electrolyte interface, and are less prone to cracking during charging and discharging, thereby improving the cycling stability of the battery.

According to the embodiments of the present invention, the three-dimensional netted structure composite material is used as the anode active material in lithium batteries, resulting in a lower volume expansion rate, higher mass specific capacity, good electrical conductivity and a longer cycle life.

### BRIEF DESCRIPTION OF THE SEVERAL VIEWS OF THE DRAWINGS

The technical solutions of the embodiments of the present invention will be described in further detail with reference to the drawings and embodiments.
Fig. 1 is a flowchart of a preparation method of a three-dimensional netted structure composite material using chemical vapor deposition according to an embodiment of the present invention.
Fig. 2 is a flowchart of a preparation method of a three-dimensional netted structure composite material using molten salt electrolysis according to an embodiment of the present invention.
Fig. 3 is a structural diagram of a cross section of a three-dimensional netted structure composite material according to an embodiment of the present invention.
Fig. 4 presents a charge-discharge curve of a button cell assembled with a three-dimensional netted structure composite material, prepared according to Embodiment 1 of the present invention.

### DETAILED DESCRIPTION OF THE INVENTION

The present invention will be further explained below by referring to drawings and specific embodiments, but it should be understood that these embodiments are only for more detailed explanation, and should not be construed as limiting the present invention in any way, that is, not intended to limit the scope of protection of the present invention.

An embodiment of the present invention provides a three-dimensional netted structure composite material for lithium batteries, comprising porous carbon microspheres with netted structure through holes, silicon nanowires distributed within the through holes of the porous carbon microspheres, and a carbon shell; and a particle size Dv50 of the three-dimensional netted structure composite material ranges from 1 µm to 100 µm, preferably 20 µm.

The silicon nanowires are formed by catalyzing ,by means of Au or Ag, silicon-containing gas and depositing the same in the through holes. It includes Au or Ag is first evaporated and deposited onto walls of the through holes of the porous carbon microspheres to create an Au or Ag metallic membrane, and then, the silicon-containing gas is introduced, and is catalyzed by Au or Ag , so that silicon atoms are precipitated and deposited in the through holes to form the silicon nanowires;

alternatively, silicon nanowires is formed by depositing silane gas in the through holes to form silicon dioxide nanoparticles , and then electrolyzing the silica dioxide nanoparticles in a molten salt system to yield the silicon nanowires.

The silicon nanowires are one-dimensional semiconductor nanomaterials, and form a three-dimensional netted structure within the through holes of the porous carbon microspheres; and the silicon nanowires account for 15% to 60% of the total mass of the three-dimensional netted structure composite material, preferably 45%.

An average pore diameter of the through holes of the porous carbon microspheres ranges from 15 nm to 50 nm; and the porous carbon microspheres account for 30% to 70% of the total mass of the three-dimensional netted structure composite material, preferably 50%.

The carbon shell envelops an outermost layer of the three-dimensional netted structure composite material, and the carbon shell accounts for 1% to 20% of the total mass of the three-dimensional netted structure composite material, preferably 5%.

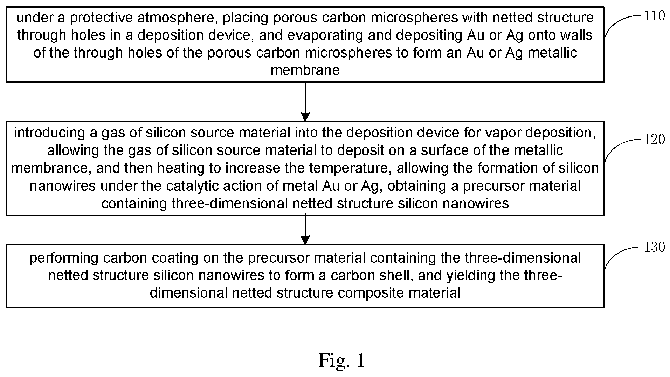

An embodiment of the present invention provides a preparation method of the three-dimensional netted structure composite material as described above, which is a chemical vapor deposition method, as shown in Fig. 1, and comprises the following steps.

Step 110, under a protective atmosphere, placing porous carbon microspheres with netted structure through holes in a deposition device, and evaporating and depositing Au or Ag onto walls of the through holes of the porous carbon microspheres to form an Au or Ag metallic membrane.

Here, the protective gas is nitrogen or argon, and a flow rate of the protective gas is 1 L/min to 50 L/min; and the deposition device comprises any one of a rotary furnace, a tube furnace, a bell jar furnace or a fluidized bed.

The process for evaporating and depositing Au or Ag is a standard procedure which includes: placing Au or Ag in a tungsten, molybdenum, or alumina crucible, and then placing the same in a vacuum heating furnace; under a vapor pressure of 1 Pa to 10⁻² Pa, increasing the temperature to 1200°C to 1400°C, causing Au or Ag to evaporate into gas; and then introducing the Au or Ag gas into the deposition device, allowing the gas to cool and deposit onto the walls of the through holes of the porous carbon microspheres, with the deposition time ranging from 10 minutes to 30 minutes, and forming an Au or Ag metallic membrane with a thickness of 1 nm to 20 nm.

Step 120, introducing a gas of silicon source material into the deposition device for vapor deposition, allowing the gas of silicon source material to deposit on a surface of the metallic membrance, and then heating to increase the temperature, allowing the formation of silicon nanowires under the catalytic action of metal Au or Ag, obtaining a precursor material containing three-dimensional netted structure silicon nanowires.

Here, the silicon source material comprises silicon-containing gas and/or silicon-containing liquid; the silicon-containing gas comprises silane and/or dichlorosilane; the silicon-containing liquid comprises one or more of propyl silane, trichlorosilane, tetrachlorosilane, trimethoxysilane, tetramethoxysilane, triethoxysilane and tetraethoxysilane;
when the silicon source material is in the form of silicon-containing gas, the silicon-containing gas is introduced directly or via a carrier gas into the deposition device, a flow rate of the directly introduced silicon-containing gas is 0.5 L/min to 50 L/min, and the carrier gas is nitrogen or argon, with a flow rate between 0.5 L/min and 50 L/min; and
when the silicon source material is in the form of silicon-containing liquid, the silicon-containing liquid is introduced into the deposition device in a bubbling form using a carrier gas, and the carrier gas is nitrogen or argon, with a flow rate between 0.5 L/min and 50 L/min.

The gas of silicon source material is subjected to vapor deposition at the temperature of 600°C-1200°C for 1-20 hours.

In an alternative solution, the method for introducing the gas of silicon source material into the deposition device for vapor deposition may be a thermal plasma technique, which includes i: placing industrial silicon powder in a high-temperature zone of a plasma device, while the porous carbon microspheres with the netted structure through holes in a condensation zone of the plasma device, allowing the thermal plasma device to vaporize and dissociate the industrial silicon powder into a silicon-containing plasma gas, which is then carried by a carrier gas into the condensation zone to deposit into pores of the porous carbon microspheres with the netted structure through holes.

The process of forming the silicon nanowires is as follows: introducing the gas of silicon source material into the deposition device via a carrier gas for vapor deposition, allowing the gas of silicon source material to deposit on a surface of the metallic membrane; and heating to 370°C, causing the Au or Ag in the metallic membrane to react with silicon, forming metallic silicon alloy droplets, during which process silicon atoms from the gas of silicon source material are absorbed by the metallic silicon alloy droplets, and precipitate and deposit between the metallic membrane and a substrate when reaching a supersaturated state in the metallic silicon alloy droplets, resulting in the formation of silicon nuclei, which continue to deposit to create the silicon nanowires. The silicon nanowires form a three-dimensional netted structure structure within the through holes of the porous carbon microspheres. The diameter of the formed silicon nanowires is 10 nm.

Step 130, performing carbon coating on the precursor material containing the three-dimensional netted structure silicon nanowires to form a carbon shell, and yielding the three-dimensional netted structure composite material.

Here, the method for carbon coating comprises any one of gas phase coating, liquid phase coating and solid phase coating; and the carbon shell formed by the carbon coating accounts for 1% to 20% of the total mass of the three-dimensional netted structure composite material.

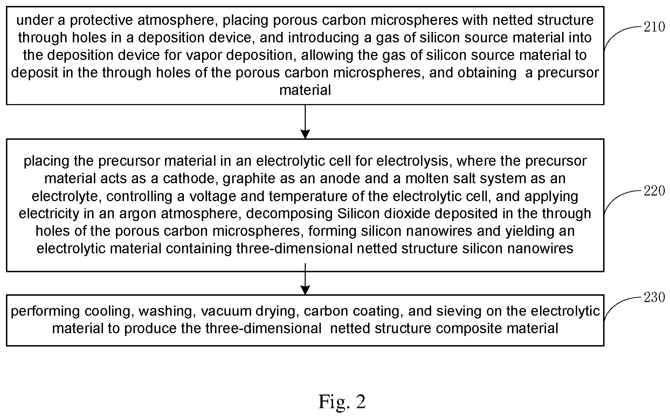

An embodiment of the present invention provides a preparation method of the three-dimensional netted structure composite material as described above, which is a molten salt electrolysis method, as shown in Fig. 2, and comprises the following steps.

Step 210, under a protective atmosphere, placing porous carbon microspheres with netted structure through holes in a deposition device, and introducing a gas of silicon source material into the deposition device for vapor deposition, allowing the gas of silicon source material to deposit in the through holes of the porous carbon microspheres, and obtaining a precursor material.

Here, the protective gas is nitrogen or argon, and a flow rate of the protective gas is 1 L/min to 50 L/min; the deposition device comprises any one of a rotary furnace, a tube furnace, a bell jar furnace or a fluidized bed; and the deposition occurs at temperatures between 600°C and 1200°C, lasting from 1 hour to 20 hours.

Alternatively, the method for introducing the gas of silicon source material into the deposition device for vapor deposition may be a thermal plasma technique, which includes: placing industrial silicon powder in a high-temperature zone of a plasma device, while placing the porous carbon microspheres with the netted structure through holes in a condensation zone of the plasma device, vaporizing and dissociating the industrial silicon powder into a silicon-containing plasma gas by the thermal plasma device, and then introducing the silicon-containing plasma gas by a carrier gas into the condensation zone to deposit into pores of the porous carbon microspheres with the netted structure through holes.

Step 220, placing the precursor material in an electrolytic cell for electrolysis, where the precursor material acts as a cathode, graphite as an anode and a molten salt system as an electrolyte, controlling a voltage and temperature of the electrolytic cell, and applying electricity in an argon atmosphere, decomposing silicon dioxide deposited in the through holes of the porous carbon microspheres , forming silicon nanowires and yielding an electrolytic material containing three-dimensional netted structure silicon nanowires.

Here, the silicon source material comprises silicon-containing gas and/or silicon-containing liquid; the silicon-containing gas comprises silane and/or dichlorosilane; the silicon-containing liquid comprises one or more of propyl silane, trichlorosilane, tetrachlorosilane, trimethoxysilane, tetramethoxysilane, triethoxysilane and tetraethoxysilane;
when the silicon source material is in the form of silicon-containing gas, the silicon-containing gas is introduced directly into the deposition device, and a flow rate of the silicon-containing gas is 0.5 L/min to 50 L/min; and
when the silicon source material is in the form of silicon-containing liquid, the silicon-containing liquid is introduced into the deposition device in a bubbling form using a carrier gas, and the carrier gas is nitrogen or argon, with a flow rate between 0.5 L/min and 50 L/min.

In the process of forming the silicon nanowires using the electrolytic method provided in this embodiment, the molten salt system specifically consists of CaCl₂-NaCl. The voltage of the electrolytic cell is controlled to be between 2 V and 3.2 V, and the temperature of the electrolytic cell ranges from 550°C to 1000°C, with electricity applied for 5 hours to 20 hours under an argon atmosphere. The diameter of the formed silicon nanowires is 10 nm.

Step 230, performing cooling, washing, vacuum drying, carbon coating, and sieving on the electrolytic material to produce the three-dimensional netted structure composite material.

Here, the method for carbon coating comprises any one of gas phase coating, liquid phase coating and solid phase coating; and the carbon shell formed by the carbon coating accounts for 1% to 20% of the total mass of the three-dimensional netted structure composite material, preferably 5%.

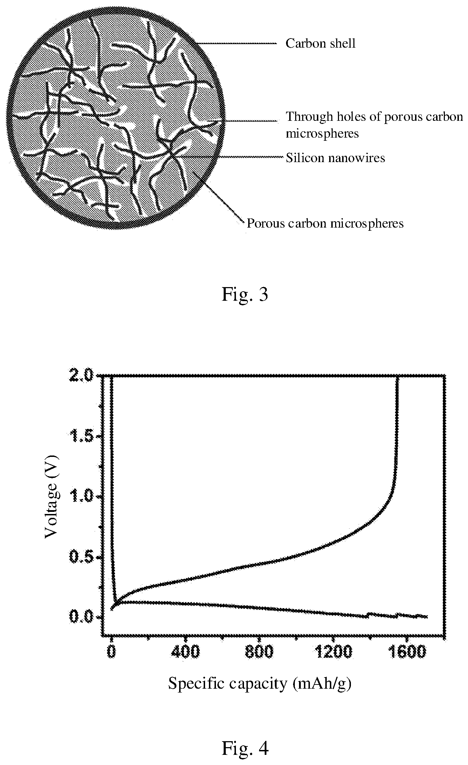

The structural diagram of the three-dimensional netted structure composite material prepared by the aforementioned two methods is shown in Fig. 3. It can be seen that silicon nanowires with a netted structure structure are formed within the through holes of the porous carbon microspheres. The silicon nanowires are one-dimensional semiconductor nanomaterials. During the battery charge and discharge process, the volume expansion rate of the silicon nanowires is lower than that of nano-silicon particles, thereby avoiding the issue of nano-silicon particle pulverization. This effectively controls the stability of the SEI membrane on the surface of the anode material particles, preventing the continuous consumption of lithium ions by the SEI membrane and reducing the likelihood of cracking during charge and discharge, thus enhancing the cycling stability of the battery. Additionally, the silicon nanowires form an interwoven three-dimensional netted structure structure within the through holes, which not only increases the capacity of the material but also forms an interconnected conductive network, enabling the battery assembled with the anode material to have a higher charge specific capacity and superior conductive performance.

The three-dimensional netted structure composite material provided by the embodiment of the invention can be used as the anode active material in lithium batteries.

Lithium batteries using the three-dimensional netted structure composite material of the present invention as the negative active material may include, but not limited to: liquid lithium-ion batteries, semi-solid lithium-ion batteries, quasi-solid lithium-ion batteries, and all-solid-state electrolyte lithium-ion batteries.

Lithium batteries prepared with the negative material provided in this embodiment of the invention have a lower volume expansion rate, higher mass specific capacity, good electrical conductive performance and a longer cycle life.

In order to better understand the technical solutions provided by the present invention, the preparation process and characteristics of the three-dimensional netted structure composite material are described below with several exemplary embodiments .

### Embodiment 1

This embodiment provides a preparation process and performance test for a three-dimensional netted structure composite material using a chemical vapor deposition method. The steps are as follows:
(1) under a nitrogen atmosphere with a flow rate of 50 L/min, placing porous carbon microspheres with netted structure through holes in a rotary furnace, and depositing an Au gas onto walls of the through holes of the porous carbon microspheres to form an Au metallic membrane;
(2) introducing methylsilane into the rotary furnace through a nitrogen carrier gas at a flow rate of 50 L/min for vapor deposition, allowing the silicon-containing gas to deposit on the surface of the Au metallic membrane at a temperature of 600°C, with deposition lasting 1 hour, and then increasing the temperature to 370°C, allowing the formation of silicon nanowires under the catalytic action of metal Au, resulting in a precursor material containing three-dimensional netted structure silicon nanowires; and
(3) performing gas phase coating on the precursor material containing the three-dimensional netted structure silicon nanowires to form a carbon shell, yielding the three-dimensional netted structure composite material.

The three-dimensional netted structure composite material prepared by this embodiment was used to prepare negative plates, and button cells were assembled for testing.

The specific process for preparing negative plates is as follows. The three-dimensional netted structure composite material, carbon black serving as a conductive additive, and a binder (sodium carboxymethyl cellulose and butadiene styrene rubber in a mass ratio of 1:1) were weighed according to the mass ratio of 95:2:3, and put in a beater at room temperature to prepare slurry. The prepared slurry was evenly applied to copper foil. After being dried in a blast drying oven at 50°C for 2 hours, the material was cut into 8×8 mm plates which are placed in a vacuum drying oven, and then vacuum drying was performed in the vacuum drying oven at 100°C for 10 hours. The dried plates were immediately transferred into a glove box for battery assembly.

The process for assembling button cells is as follows. Simulated battery assembly was performed in a glove box containing high purity Ar atmosphere, with lithium metal serving as a counter electrode, a solution of ethylene carbonate (EC)/dimethyl carbonate (DMC) (v:v=1:1) containing 1 mol/L LiPF₆ as an electrolyte, and a polyethylene membrane as a separator.

The testing method is as follows. A constant current charge-discharge mode test was carried out by using a charge-discharge instrument. The discharge cut-off voltage was 0.005 V and the charge cut-off voltage was 1.5 V. The charge-discharge test was carried out at C/10 current density. The charge specific capacity and initial-cycle Coulombic efficiency of the button cell were measured, with the test results detailed in Table 1.

A charge-discharge curve of a button cell assembled with a three-dimensional netted structure composite material prepared according to this embodiment of the invention is shown in Fig. 4.

### Embodiment 2

This embodiment provides a preparation process and performance test for a three-dimensional netted structure composite material using a chemical vapor deposition method. The steps are as follows:
(1) under an argon atmosphere with a flow rate of 40 L/min, placing porous carbon microspheres with netted structure through holes in a tube furnace, and depositing an Ag gas onto walls of the through holes of the porous carbon microspheres to form an Ag metallic membrane;
(2) introducing trisilane into the tube furnace in a bubbling form through an argon carrier gas at a flow rate of 40 L/min for vapor deposition, allowing the silicon-containing gas to deposit on the surface of the Ag metallic membrane at a temperature of 800°C, with deposition lasting 5 hours, and then heating to 370°C, allowing the formation of silicon nanowires under the catalytic action of metal Ag, resulting in a precursor material containing three-dimensional netted structure silicon nanowires; and
(3) performing gas phase coating on the precursor material containing the three-dimensional netted structure silicon nanowires to form a carbon shell, yielding the three-dimensional netted structure composite material.

The three-dimensional netted structure composite material prepared by this embodiment was used to prepare negative plates, and button cells were assembled for testing. The specific processes are the same as in Embodiment 1, and the test results are detailed in Table 1.

### Embodiment 3

This embodiment provides a preparation process and performance test for a three-dimensional netted structure composite material using a chemical vapor deposition method. The specific steps are as follows:
(1) under a nitrogen atmosphere with a flow rate of 30 L/min, placing porous carbon microspheres with netted structure through holes in a bell jar furnace, and depositing an Au gas onto walls of the through holes of the porous carbon microspheres to form an Au metallic membrane;
(2) introducing dichlorosilane into the bell jar furnace through a nitrogen carrier gas at a flow rate of 30 L/min for vapor deposition, allowing the silicon-containing gas to deposit on the surface of the Au metallic membrane at a temperature of 900°C, with deposition lasting 10 hours, and then heating to 370°C, allowing the formation of silicon nanowires under the catalytic action of metal Au, resulting in a precursor material containing three-dimensional netted structure silicon nanowires; and
(3) performing liquid phase coating on the precursor material containing the three-dimensional netted structure silicon nanowires to form a carbon shell, yielding the three-dimensional netted structure composite material.

The three-dimensional netted structure composite material prepared by this embodiment was used to prepare negative plates, and button cells were assembled for testing. The specific processes are the same as in Embodiment 1, and the test results are detailed in Table 1.

### Embodiment 4

This embodiment provides a preparation process and performance test for a three-dimensional netted structure composite material using a chemical vapor deposition method. The specific steps are as follows:
(1) under an argon atmosphere with a flow rate of 10 L/min, placing porous carbon microspheres with netted structure through holes in a fluidized bed, and depositing an Ag gas onto walls of the through holes of the porous carbon microspheres to form an Ag metallic membrane;
(2) introducing a mixed liquid of trichlorosilane and tetrachlorosilane into the fluidized bed in a bubbling form through an argon carrier gas at a flow rate of 5 L/min for vapor deposition, allowing the silicon-containing gas to deposit on the surface of the Ag metallic membrane at a temperature of 1000°C, with deposition lasting 15 hours, and then heating h to 370°C, allowing the formation of silicon nanowires under the catalytic action of metal Ag, resulting in a precursor material containing three-dimensional netted structure silicon nanowires; and
(3) performing gas phase coating on the precursor material containing the three-dimensional netted structure silicon nanowires to form a carbon shell, yielding the three-dimensional netted structure composite material.

The three-dimensional netted structure composite material prepared by this embodiment was used to prepare negative plates, and button cells were assembled for testing. The processes are the same as in Embodiment 1, and the test results are detailed in Table 1.

Button cells were assembled according to the method described in Embodiment 1 above, and their electrochemical performance was evaluated through testing. The test results are recorded in Table 1.

### Embodiment 5

This embodiment provides a preparation process and performance test for a three-dimensional netted structure composite material using a chemical vapor deposition method. The specific steps are as follows:
(1) under a nitrogen atmosphere with a flow rate of 1 L/min, placing porous carbon microspheres with netted structure through holes in a fluidized bed, and depositing an Au gas onto walls of the through holes of the porous carbon microspheres to form an Au metallic membrane;
(2) directly introducing silane and dichlorosilane serving as gas silicon sources into the fluidized bed at a flow rate of 0.5 L/min for vapor deposition, allowing the silicon-containing gas to deposit on the surface of the Au metallic membrane at a temperature of 1200°C, with deposition lasting 20 hours, and then increasing the temperature to 370°C, allowing the formation of silicon nanowires under the catalytic action of metal Au, resulting in a precursor material containing three-dimensional netted structure silicon nanowires; and
(3) performing gas phase coating on the precursor material containing the three-dimensional netted structure silicon nanowires to form a carbon shell, yielding the three-dimensional netted structure composite material.

The three-dimensional netted structure composite material prepared by this embodiment was used to prepare negative plates, and button cells were assembled for testing. The specific processes are the same as in Embodiment 1, and the test results are detailed in Table 1.

### Embodiment 6

This embodiment provides a preparation process and performance test for a three-dimensional netted structure composite material.
The steps are as follows:
(1) under a nitrogen atmosphere with a flow rate of 10 L/min, placing porous carbon microspheres with netted structure through holes in a rotary furnace, and depositing an Au gas onto walls of the through holes of the porous carbon microspheres to form an Au metallic membrane;
(2) using a thermal plasma method to perform gas-phase deposition, i includes tti: placing industrial silicon powder serving as the silicon source material in a high-temperature zone of a plasma treatment device, while the porous carbon microspheres with the Au metallic membrane in the through holes in a condensation zone of the plasma treatment device, allowing the plasma treatment device to vaporize and dissociate the industrial silicon powder into a silicon-containing plasma gas, which was then carried by a carrier gas into the condensation zone, allowing the silicon-containing gas to deposit onto the surface of the Au metallic membrane;
(3) placing the deposited material from step (2) in a rotary furnace, and then increasing the temperature to 370°C, allowing the formation of silicon nanowires under the catalytic action of metal Au, resulting in a precursor material containing three-dimensional netted structure silicon nanowires; and
(4) performing gas phase coating on the precursor material containing the three-dimensional netted structure silicon nanowires to form a carbon shell, yielding the three-dimensional netted structure composite material.

The three-dimensional netted structure composite material prepared by this embodiment was used to prepare negative plates, and button cells were assembled for testing. The specific processes are the same as in Embodiment 1, and the test results are detailed in Table 1.

### Embodiment 7

This embodiment provides a preparation process and performance test for a three-dimensional netted structure composite material using a molten salt electrolysis method. The specific steps are as follows:
(1) under an argon atmosphere at a flow rate of 50 L/min, placing porous carbon microspheres with netted structure through holes in a tube furnace, and introducing trimethoxysilane into the tube furnace in a bubbling form through an argon carrier gas at a flow rate of 50 L/min for vapor deposition at 600°C, with deposition lasting 1 hour, allowing the silicon-containing gas to deposit into the through holes of the porous carbon microspheres, resulting in a precursor material;
(2) placing the precursor material in an electrolytic cell for electrolysis, where the precursor material acted as a cathode, graphite as an anode and a CaCl₂-NaCl molten salt system as an electrolyte, controlling the voltage of the electrolytic cell at 2 V and the temperature at 550°C, and applying electricity in an argon atmosphere for 20 hours,decomposing silicon dioxide deposited in the through holes of the porous carbon microspheres , forming silicon nanowires and yielding an electrolytic material containing three-dimensional netted structure silicon nanowires; and
(3) performing cooling, washing, vacuum drying, carbon coating, and sieving on the electrolytic material to produce the three-dimensional netted structure composite material.

The three-dimensional netted structure composite material prepared by this embodiment was used to prepare negative plates, and button cells were assembled for testing. The specific processes are the same as in Embodiment 1, and the test results are detailed in Table 1.

### Embodiment 8

This embodiment provides a preparation process and performance test for a three-dimensional netted structure composite material using a molten salt electrolysis method. The specific steps are as follows:
(1) under an argon atmosphere at a flow rate of 40 L/min, placing porous carbon microspheres with netted structure through holes in a tube furnace, and introducing tetramethoxysilane into the tube furnace in a bubbling form through an argon carrier gas at a flow rate of 40 L/min for vapor deposition at 800°C, with deposition lasting 5 hours, allowing the silicon-containing gas to deposit into the through holes of the porous carbon microspheres, resulting in a precursor material;
(2) placing the precursor material in an electrolytic cell for electrolysis, where the precursor material acted as a cathode, graphite as an anode and a CaCl₂-NaCl molten salt system as an electrolyte, controlling the voltage of the electrolytic cell at 2.2 V and the temperature at 600°C, and applying electricity in an argon atmosphere for 18 hours, decomposing silicon dioxide deposited in the through holes of the porous carbon microspheres, forming silicon nanowires and yielding an electrolytic material containing three-dimensional netted structure silicon nanowires; and
(3) performing cooling, washing, vacuum drying, carbon coating, and sieving on the electrolytic material to produce the three-dimensional netted structure composite material.

The three-dimensional netted structure composite material prepared by this embodiment was used to prepare negative plates, and button cells were assembled for testing. The specific processes are the same as in Embodiment 1, and the test results are detailed in Table 1.

Button cells were assembled according to the method described in Embodiment 1 above, and their electrochemical performance was evaluated through testing. The test results are recorded in Table 1.

### Embodiment 9

This embodiment provides a preparation process and performance test for a three-dimensional netted structure composite material using a molten salt electrolysis method. The steps are as follows:
(1) under an argon atmosphere at a flow rate of 30 L/min, placing porous carbon microspheres with netted structure through holes in a bell jar furnace, and introducing triethoxysilane into the bell jar furnace in a bubbling form through an argon carrier gas at a flow rate of 30 L/min for vapor deposition at 1000°C, with deposition lasting 10 hours, allowing the silicon-containing gas to deposit into the through holes of the porous carbon microspheres, resulting in a precursor material;
(2) placing the precursor material in an electrolytic cell for electrolysis, where the precursor material acted as a cathode, graphite as an anode and a CaCl₂-NaCl molten salt system as an electrolyte, controlling the voltage of the electrolytic cell at 2.5 V and the temperature at 800°C, and applying electricity in an argon atmosphere for 15 hours, causing silicon dioxide deposited in the through holes of the porous carbon microspheres to decompose, forming silicon nanowires and yielding an electrolytic material containing three-dimensional netted structure silicon nanowires; and
(3) performing cooling, washing, vacuum drying, carbon coating, and sieving on the electrolytic material to produce the three-dimensional netted structure composite material.

The three-dimensional netted structure composite material prepared by this embodiment was used to prepare negative plates, and button cells were assembled for testing. The processes are the same as in Embodiment 1, and the test results are detailed in Table 1.

### Embodiment 10

This embodiment provides a preparation process and performance test for a three-dimensional netted structure composite material using a molten salt electrolysis method. The steps are as follows:
(1) under an argon atmosphere at a flow rate of 10 L/min, placing porous carbon microspheres with netted structure through holes in a bell jar furnace, and introducing tetraethoxysilane into the bell jar furnace in a bubbling form through an argon carrier gas at a flow rate of 10 L/min for vapor deposition at 1100°C, with deposition lasting 15 hours, allowing the silicon-containing gas to deposit into the through holes of the porous carbon microspheres, resulting in a precursor material;
(2) placing the precursor material in an electrolytic cell for electrolysis, where the precursor material acted as a cathode, graphite as an anode and a CaCl₂-NaCl molten salt system as an electrolyte, controlling the voltage of the electrolytic cell at 2.7 V and the temperature at 900°C, and applying electricity in an argon atmosphere for 10 hours, causing silicon dioxide deposited in the through holes of the porous carbon microspheres to decompose, forming silicon nanowires and yielding an electrolytic material containing three-dimensional netted structure silicon nanowires; and
(3) performing cooling, washing, vacuum drying, carbon coating, and sieving on the electrolytic material to produce the three-dimensional netted structure composite material.

The three-dimensional netted structure composite material prepared by this embodiment was used to prepare negative plates, and button cells were assembled for testing. The processes are the same as in Embodiment 1, and the test results are detailed in Table 1.

### Embodiment 11

This embodiment provides a preparation process and performance test for a three-dimensional netted structure composite material using a molten salt electrolysis method. The specific steps are as follows:
(1) under an argon atmosphere at a flow rate of 1 L/min, placing porous carbon microspheres with netted structure through holes in a bell jar furnace, and introducing a liquid of trimethoxysilane and tetramethoxysilane into the bell jar furnace in a bubbling form through an argon carrier gas at a flow rate of 0.5 L/min for vapor deposition at 1200°C, with deposition lasting 20 hours, allowing the silicon-containing gas to deposit into the through holes of the porous carbon microspheres, resulting in a precursor material;
(2) placing the precursor material in an electrolytic cell for electrolysis, where the precursor material acted as a cathode, graphite as an anode and a CaCl₂-NaCl molten salt system as an electrolyte, controlling the voltage of the electrolytic cell at 3.2 V and the temperature at 1000°C, and applying electricity in an argon atmosphere for 5 hours, causing silicon dioxide deposited in the through holes of the porous carbon microspheres to decompose, forming silicon nanowires and yielding an electrolytic material containing three-dimensional netted structure silicon nanowires; and
(3) performing cooling, washing, vacuum drying, carbon coating, and sieving on the electrolytic material to produce the three-dimensional netted structure composite material.

The three-dimensional netted structure composite material prepared by this embodiment was used to prepare negative plates, and button cells were assembled for testing. The specific processes are the same as in Embodiment 1, and the test results are detailed in Table 1.

In order to better illustrate the effect of the embodiments of the present invention, Comparative example 1 and Comparative example 2 are compared with the embodiments.

### Comparative example 1

This comparative example provides a preparation method and performance test for a traditional silicon-carbon composite material. The specific steps are as follows:
(1) placing 200 g of nano silicon particles and 500 g of phenolic resin powder in a hydrothermal reactor for hydrothermal reaction, the conditions of hydrothermal reaction being that the pressure was 5 Mpa, the heating temperature was 300°C, and the temperature was kept for 8 hours, then cleaning and filtering discharged materials until a filtrate became transparent and colorless, and then placing the filtered material in a vacuum drying oven for drying, yielding a precursor; and
(2) mixing the precursor uniformly and placing the same in a high-temperature furnace, heating at a rate of 3°C/min to 900°C, and maintaining this temperature in a nitrogen atmosphere for 6 hours for carbonization, resulting in a silicon-carbon composite material.

The silicon-carbon composite material prepared by this comparative example was used to prepare negative plates, and button cells were assembled for testing. The specific processes are the same as in Embodiment 1, and the test results are detailed in Table 1.

### Comparative example 2

This comparative example provides a preparation process and performance test for a silicon-carbon composite material using a chemical vapor deposition method. The specific steps are as follows:
(1) under a nitrogen atmosphere at a flow rate of 50 L/min, introducing silicane into a rotary furnace through a nitrogen carrier gas at a flow rate of 50 L/min for vapor deposition at 600°C, with deposition lasting 1 hour, allowing the silicon-containing gas to deposit onto walls of through holes of porous carbon microspheres, resulting in a precursor material; and
(2) performing gas phase coating on the precursor material to form a carbon shell, yielding the three-dimensional netted structure composite material.

The silicon-carbon composite material prepared by this comparative example was used to prepare negative plates, and button cells were assembled for testing. The specific processes are the same as in Embodiment 1, and the test results are detailed in Table 1.

Table 1 shows the test results of the charging specific capacity and initial-cycle Coulombic efficiency for the button cells assembled in Embodiments 1-11 and Comparative example 1.

| **No.** | **Charge specific capacity (mAh/g)** | **initial-cycle Coulombic efficiency (%)** |
|---|---|---|
| Embodiment 1 | 1547 | 90.76 |
| Embodiment 2 | 1568 | 90.75 |
| Embodiment 3 | 1564 | 90.77 |
| Embodiment 4 | 1568 | 90.86 |
| Embodiment 5 | 1572 | 91.15 |
| Embodiment 6 | 1579 | 91.68 |
| Embodiment 7 | 1580 | 91.49 |
| Embodiment 8 | 1592 | 91.92 |
| Embodiment 9 | 1587 | 91.14 |
| Embodiment 10 | 1582 | 92.06 |
| Embodiment 11 | 1603 | 91.21 |
| Comparative example 1 | 1212 | 78.92 |
| Comparative example 2 | 1502 | 88.68 |

By comparing the test data in Table 1, it can be seen that the charging specific capacity and initial-cycle Coulomb efficiency of the button cells assembled using the three-dimensional netted structure composite materials in Embodiments 1-11 are superior to those assembled in Comparative examples 1-2. This is because the three-dimensional netted structure composite materials prepared in Embodiments 1-11 involve in-situ generation of silicon nanowires within the through holes of the porous carbon microspheres. On the one hand, the through holes of the porous carbon microspheres serve as the skeleton structure, possessing high mechanical strength. When subjected to the expansion force of lithium intercalation, the high-strength skeleton structure can effectively inhibit the volume expansion of the silicon nanowires, maintain the structural stability of the negative material, and improve the cycling performance of the material. On the other hand, the silicon nanowires form an interwoven three-dimensional netted structure structure within the through holes, which not only increases the capacity of the material but also forms an interconnected conductive network, enabling the anode material to have a higher charge specific capacity and superior conductive performance. In addition, compared to silicon particles, the three-dimensional netted structure silicon nanowires exhibit better electrical conductivity, possess superior conductive properties at an electrode/electrolyte interface, and are less prone to cracking during charging and discharging, thereby improving the cycling stability of the battery.

The above-mentioned specific embodiments further explain the purpose, technical solution and beneficial effects of the present invention in detail. It should be understood that the above are only specific embodiments of the present invention and are not used to limit the scope of protection of the present invention. Any modification, equivalent substitution, improvement, etc. made within the spirit and principles of the present invention should be included in the scope of protection of the present invention.

## Claims

1. A three-dimensional netted structure composite material for lithium batteries, comprising porous carbon microspheres with netted structure through holes, silicon nanowires distributed within the through holes of the porous carbon microspheres, and a carbon shell;
wherein the silicon nanowires are formed by catalyzing a silicon-containing gas by Au or Ag and depositing same in the through holes ; including, Au or Ag is first evaporated and deposited onto walls of the through holes of the porous carbon microspheres to create an Au or Ag metallic membrane, and then, the silicon-containing gas is introduced, allowing Au or Ag to catalyze the silicon-containing gas, so that precipitating silicon atoms ,depositing the silicon atoms in the through holes to form the silicon nanowires;
alternatively, the silicon nanowires are formed by depositing silane gas in the through holes to form silicon dioxide nanoparticles, and electrolyzing the silicon dioxide nanoparticles in the through holes under a molten salt system ;
the silicon nanowires form a three-dimensional netted structure structure in the through holes of the porous carbon microspheres; and
an average pore diameter of the through holes of the porous carbon microspheres ranges from 15 nm to 50 nm.

2. The three-dimensional netted structure composite material according to claim 1, wherein
the porous carbon microspheres account for 30% to 70% of the total mass of the three-dimensional netted structure composite material;
the silicon nanowires account for 15% to 60% of the total mass of the three-dimensional netted structure composite material; and
a particle size Dv50 of the three-dimensional netted structure composite material ranges from 1 µm to 100 µm.

3. The three-dimensional netted structure composite material according to claim 1, wherein the carbon shell envelops an outermost layer of the three-dimensional netted structure composite material, and the carbon shell accounts for 1% to 20% of the total mass of the three-dimensional netted structure composite material.

4. A preparation method of the three-dimensional netted structure composite material according to any one of claims 1-3, comprising:
under a protective atmosphere, placing porous carbon microspheres with netted structure through holes in a deposition device, and evaporating and depositing Au or Ag onto walls of the through holes of the porous carbon microspheres to form an Au or Ag metallic membrane that acts as a catalyst;
introducing a gas of silicon source material into the deposition device for vapor deposition, allowing the gas of silicon source material to deposit on a surface of the metallic membrane, and then heating to increase the temperature, forming silicon nanowires under the catalytic action of metal Au or Ag, to obtain a precursor material containing three-dimensional netted structure silicon nanowires; and
performing carbon coating on the precursor material containing the three-dimensional netted structure silicon nanowires to form a carbon shell, yielding the three-dimensional netted structure composite material.

5. The preparation method of the three-dimensional netted structure composite material according to claim 4, wherein the protective gas is nitrogen or argon, and a flow rate of the protective gas is 1 L/min to 50 L/min;
the silicon source material comprises silicon-containing gas and/or silicon-containing liquid;
the silicon-containing gas comprises silane and/or dichlorosilane;
the silicon-containing liquid comprises one or more of propyl silane, trichlorosilane, tetrachlorosilane, trimethoxysilane, tetramethoxysilane, triethoxysilane and tetraethoxysilane;
when the silicon source material is in the form of silicon-containing gas, the silicon-containing gas is introduced directly or via a carrier gas into the deposition device, a flow rate of the silicon-containing gas is 0.5 L/min to 50 L/min, and the carrier gas is nitrogen or argon, with a flow rate between 0.5 L/min and 50 L/min; and
when the silicon source material is in the form of silicon-containing liquid, the silicon-containing liquid is introduced into the deposition device in a bubbling form using a carrier gas, and the carrier gas is nitrogen or argon, with a flow rate between 0.5 L/min and 50 L/min.

6. The preparation method of the three-dimensional netted structure composite material according to claim 4, wherein the deposition device comprises any one of a rotary furnace, a tube furnace, a bell jar furnace or a fluidized bed;
the gas of silicon source material is introduced into the deposition device for vapor deposition at the temperature of 600°C-1200°C for 1-20 hours;
the method for carbon coating comprises any one of gas phase coating, liquid phase coating and solid phase coating; the carbon shell formed by the carbon coating accounts for 1% to 20% of the total mass of the three-dimensional netted structure composite material; and
the method for introducing the gas of silicon source material into the deposition device for vapor deposition comprises a thermal plasma technique.

7. A preparation method of the three-dimensional netted structure composite material according to any one of claims 1-3, comprising:
under a protective atmosphere, placing porous carbon microspheres with netted structure through holes in a deposition device, and introducing a gas of silicon source material into the deposition device for vapor deposition, depositing the gas of silicon source material in the through holes of the porous carbon microspheres,to obtain a precursor material;
placing the precursor material in an electrolytic cell for electrolysis, where the precursor material acts as a cathode, graphite as an anode and a molten salt system as an electrolyte, controlling a voltage and temperature of the electrolytic cell, and applying electricity in an argon atmosphere, decomposing silicon dioxide deposited in the through holes of the porous carbon microspheres , forming silicon nanowires and yielding an electrolytic material containing three-dimensional netted structure silicon nanowires; and
performing cooling, washing, vacuum drying, carbon coating, and sieving on the electrolytic material to produce the three-dimensional netted structure composite material.

8. The preparation method of the three-dimensional netted structure composite material according to claim 7, wherein the protective gas is nitrogen or argon, and a flow rate of the protective gas is 1 L/min to 50 L/min;
the silicon source material comprises silicon-containing gas and/or silicon-containing liquid;
the silicon-containing gas comprises silane and/or dichlorosilane;
the silicon-containing liquid comprises one or more of propyl silane, trichlorosilane, tetrachlorosilane, trimethoxysilane, tetramethoxysilane, triethoxysilane and tetraethoxysilane;
when the silicon source material is in the form of silicon-containing gas, the silicon-containing gas is introduced directly or via a carrier gas into the deposition device, a flow rate of the silicon-containing gas is 0.5 L/min to 50 L/min, and the carrier gas is nitrogen or argon, with a flow rate between 0.5 L/min and 50 L/min; and
when the silicon source material is in the form of silicon-containing liquid, the silicon-containing liquid is introduced into the deposition device in a bubbling form using a carrier gas, and the carrier gas is nitrogen or argon, with a flow rate between 0.5 L/min and 50 L/min.

9. The preparation method of the three-dimensional netted structure composite material according to claim 7, wherein the deposition device comprises any one of a rotary furnace, a tube furnace, a bell jar furnace or a fluidized bed;
the gas of silicon source material is introduced into the deposition device for vapor deposition at the temperature of 600°C-1200°C for 1-20 hours;
the method for carbon coating comprises any one of gas phase coating, liquid phase coating and solid phase coating;
the carbon shell formed by the carbon coating accounts for 1% to 20% of the total mass of the three-dimensional netted structure composite material; and
the method for introducing the gas of silicon source material into the deposition device for vapor deposition comprises a thermal plasma technique.

10. A lithium battery, wherein the lithium battery comprises the three-dimensional netted structure composite material according to any one of claims 1-3.
